# EUROPEAN PATENT APPLICATION

(11) **EP 4 672 608 A1**
(43) Date of publication of application: **31.12.2025**
(21) Application number: 24183964.6
(22) Date of filing: 24.06.2024
(51) Int. Cl.: H03K 17/16, H03K 17/0412

(54) **GATE DRIVER AND SWITCHING APPARATUS**

(71) Applicant: ABB SCHWEIZ AG, 5400 Baden (CH)
(72) Inventor: Puukko, Joonas, 04340 Tuusula (FI); Salmia, Teemu, 00380 Helsinki (FI); Niemi, Mika, 00380 Helsinki (FI)
(74) Representative: Kolster Oy Ab

(57) **Abstract**

A gate driver (14) includes a switching circuit outputting a gate driving voltage (V_{ge}) to a gate (G) of a semiconductor power switching device (IGBT) via a series gate resistor (R_{g}). The gate driver further includes an external controllable capacitor circuit (20) is coupled at the gate of the semiconductor power switching device (IGBT) to provide an adjustable external gate capacitance (C_{G}) in parallel with a parasitic gate or input capacitance (C_{ge}) of the IGBT. The capacitor circuit (20) may be controlled by one or more electrical signals (Con_CG) to vary the external gate capacitance (C_{G}) and thereby the characteristics of a switching operation.

## Description

### FIELD OF THE INVENTION

The invention relates to gate drivers, and more particularly to gate drivers for semiconductor power switching devices.

### BACKGROUND OF THE INVENTION

MOSFET (Metal Oxide Field Effect Transistor) and IGBT (Insulated Gate Bipolar Transistor) are essential semiconductor switching components used in the design of many circuits ranging from a simple driver circuit to complex power rectifiers and converters. MOSFET is a voltage-controlled device, in which a voltage applied to a gate controls a voltage and a current flow between a source and a drain, the MOSFET will start conducting through the drain and source pins. IGBT is a switching component with two characteristics: high-power as bipolar transistor, high-speed converting and voltage driven as MOSFET. A voltage applied to a gate controls a voltage and a current flow between a collector and an emitter. MOSFET and IGBT have similar input characteristics with some parasitic capacitances, such as a gate capacitance and an input capacitance. These capacitances have great effects on the behaviours of the semiconductor switch during a switching period.

In the most common gate control technology, the gate voltage of the IGBT or MOSFET is controlled by a gate resistor and a bipolar voltage source. An example of an IGBT gate driving control 4 using a bipolar voltage source (Vcc, Vee) 2 and a gate resistor Rg is illustrated in Fig. 1. The IGBT may be provided with an antiparallel diode D1, also called a freewheeling diode or zero diode. The turn-on and turn-off of the IGBT depend on a gate voltage V_{ge} between a gate G and an emitter E of the IGBT. The input capacitance of the IGBT consists of two nonlinear components that are commonly called the gate capacitance (C_{ge}) and the gate-collector (Miller) capacitance (C_{gc}). The input capacitance of the IGBT may be defined by the parallel connected gate-emitter capacitance C_{ge} and gate-collector Ccg capacitance, Cᵢₑₛ = C_{ge} + C_{cg}. Gate driver circuits are typically arranged to charge and discharge the gate capacitance C_{ge} (or generally the input capacitance Cin) so as to switch on and off the IGBT according to a control or gating signal(s) G1. The IGBT turn on and off speeds du/dt and di/dt (and thereby rise and fall times) of the collector voltage Vc and the collector current Ic, respectively, are determined by the gate resistor Rg and voltage source values Vcc, Vee. Duration of the gating transient is dominantly defined by the time constant of the gate resistor Rg and the IGBT input capacitance. Switching speed is not programmable, but the gate resistor would have to be changed to change the switching speed.

### BRIEF DESCRIPTION OF THE INVENTION

An object of the present invention is to provide a gate driving control which enables more flexible adjustment or programming of the switching characteristics of semiconductor switches. The objects of the invention are achieved by a gate driver circuit and a switching apparatus according to the independent claims. The preferred embodiments of the invention are disclosed in the dependent claims.

A first aspect of the invention is a gate driver comprising:
a gate driver output configured to be coupled to a gate of a semiconductor power switching device, preferably IGBT or MOSFET,
a switching circuit outputting a gate driving voltage to the gate driver output via a series gate resistor,
a controllable capacitor circuit configured to provide an adjustable external gate capacitance at the gate driver output in parallel with an internal gate capacitance of the semiconductor power switching device, the controllable capacitor circuit being selectively controllable to provide at least two different values of the external gate capacitance.

In embodiments, the controllable capacitor circuit comprises one or more controllable capacitor legs each of which can be selectively coupled and decoupled in parallel with the internal gate capacitance of the semiconductor power switching device.

In embodiments, each controllable capacitor leg comprises a capacitor connected in series with a control switch, the control switch being selectively controllable between a first state where the respective capacitor is coupled in parallel with an internal gate capacitance, and a second state where the respective capacitor is decoupled.

In embodiments, the capacitor legs can be selectively coupled and decoupled in 2ⁿ combinations to provide 2ⁿ different values of the external gate capacitance, where n is number of the capacitor legs.

In embodiments, the gate driver is configured to select a higher or highest external capacitance value in response to detecting a short circuit so as to restrict a short circuit current.

In embodiments, the gate driver is configured to select an external capacitance value that provides a desired switching delay of the semiconductor power switching device.

In embodiments, the gate driver is configured to select an external capacitance value to adjust the switching delay of the semiconductor power switching device relative to one or more parallel-connected semiconductor power switching devices such that the parallel-connected semiconductor power switching devices are switching as simultaneously as possible.

In embodiments, the gate driver is configured to select a higher external capacitance value to adjust a current rate of change di/dt of a collector current.

In embodiments, the gate driver is configured to select a higher external capacitance value to decrease a current rate of change di/dt of a collector current and to thereby decrease a magnetic field and/or a common-mode interference current caused by a switching operation.

In embodiments, the gate driver is configured to select an external capacitance value that, together with a value of the series gate resistor, results in a lower voltage rate of change du/dt with a same switching loss.

In embodiments, the gate driver is configured to dynamically adjust the external capacitance value dynamically at zero-crossing points of a sinusoidal voltage that is switched.

In embodiments, the external gate capacitance value is set or programmed at set up or calibration or dynamically during operation of a switching apparatus where a gate driver is used.

In embodiments, the external gate capacitance value is set or programmed using predetermined control settings of the controllable capacitor circuit for certain semiconductor power switching devices or modes of operation.

A second aspect of the invention is a switching apparatus, comprising
a half or full bridge circuit comprising two or more semiconductor power switching devices,
the gate driver according to the first aspect for each of the two or more semiconductor power switching devices,
a controller controlling the controllable capacitor circuits of the gate drivers to adjust the external gate capacitance values.

In embodiments, the switching apparatus comprises a power converter, an inverter, or a rectifier.

### BRIEF DESCRIPTION OF THE DRAWINGS

In the following the invention will be described in greater detail by means of exemplary embodiments with reference to the accompanying drawings, in which
Figure 1 shows a simplified circuit diagram illustrating a conventional gate driver circuit;
Figure 2 shows a simplified circuit diagram illustrating an exemplary gate driver circuit according to an embodiment;
Figure 3 shows simplified circuit diagram illustrating a half-bridge circuit having a lower switch and an upper switch with respective antiparallel freewheeling diodes;
Figure 4 shows an example of switching waveforms in the turn-on of an IGBT;
Figure 5 shows exemplary waveforms of the collector current and the collector voltage when the external gate capacitance CG has been increased compared to Fig. 4;
Figure 6 shows a simplified circuit diagram illustrating an exemplary controllable capacitor circuit according to an embodiment; and
Figure 7 shows simulated waveforms of the collector current and the collector voltage for a simple test circuit.

### DETAILED DESCRIPTION

The present invention relates generally to gate driver circuits and control methods for semiconductor power switching devices. In embodiments, a semiconductor power switching device may be MOSFET (Metal Oxide Field Effect Transistor). In other embodiments, a semiconductor power switching device may be IGBT (Insulated Gate Bipolar Transistor). Semiconductor power switching devices have some parasitic capacitances, such as a parasitic gate capacitance, or generally parasitic input capacitance. These capacitances have great effects on the behaviours of the semiconductor switching devices during switching. A gate driving voltage is applied a gate of the semiconductor power switching device via a series gate resistor.

According to an aspect of the invention a gate driver circuit is provided with a controllable capacitor circuit configured to provide an adjustable external gate capacitance at the gate driver output in parallel with a parasitic gate or input capacitance of the semiconductor power switching device, the controllable capacitor circuit being selectively electrically controllable to provide at least two different values of the external gate capacitance. With the capability of electrically controlling addition and amount of an external gate capacitance, it is possible to readily adjust the gate capacitance of a semiconductor power switching device and thereby the characteristics of a switching operation to meet requirements in each specific application.

In embodiments, the controllable capacitor circuit comprises one or more controllable capacitor legs each of which can be selectively coupled and decoupled in parallel with the parasitic gate or input capacitance of the semiconductor power switching device.

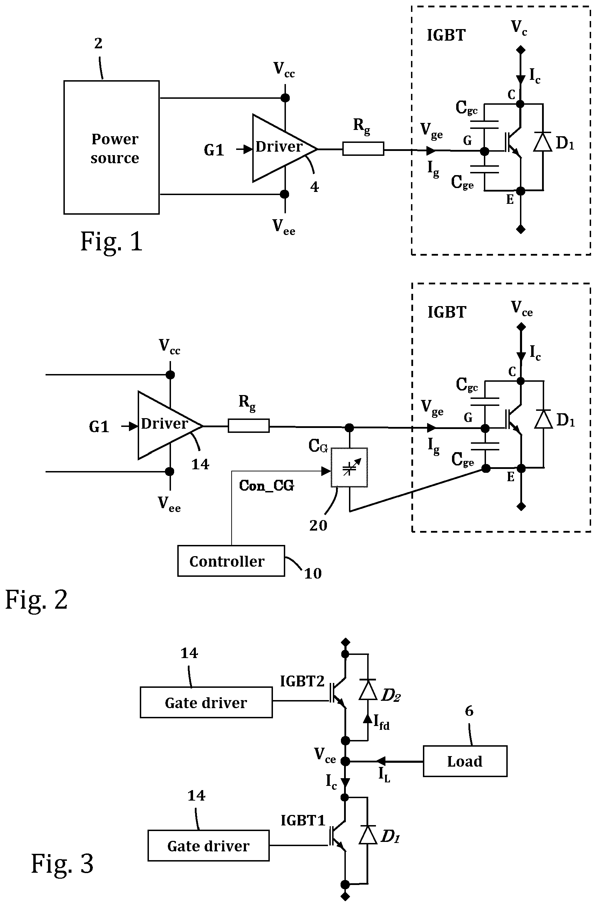

Fig. 2 shows a simplified circuit diagram illustrating an exemplary gate driver circuit according to an embodiment. The illustrated gate driving control 14 has a bipolar voltage source Vcc, Vee, and an output connected via a gate resistor Rg to a gate G of a semiconductor power switching device. The bipolar voltage source may be ±15 V, for example. The switching of the gate driving control 14 is controlled by one or more control or gating signals G1. In embodiments, the one or more control or gating signals are pulse width modulated (PWM) signals. The output of the gate driving control 14, and thereby a gate voltage may be alternately switched to the voltage Vcc and Vee (e.g., ±15 V) according to the one or more control or gating signals. This kind of so-called "voltage source" gate driver is commonly used, wherein the gate power source behaves like a voltage source to charge and discharge the gate of the semiconductor power switching device. It shall be appreciated that an implementation of the gate driving circuit, such as the circuit 14, is not essential to embodiments of invention. A gate driving voltage or current may be generated by any gate driving arrangement.

In exemplary embodiments disclosed herein, the semiconductor power switching device is IGBT, but it may as well be MOSFET. The IGBT may be provided with an antiparallel diode D1, also called a freewheeling diode or zero diode. The IGBT has parasitic capacitances. A parasitic input capacitance of the IGBT consists of two nonlinear components that are commonly called a parasitic gate capacitance (C_{ge}) and a parasitic gate-collector (Miller) capacitance (C_{gc}). The input capacitance of the IGBT may be defined by the parallel connected gate-emitter capacitance C_{ge} and gate-collector C_{cg} capacitance, Cᵢₑₛ = C_{ge} + Ccg. The parasitic capacitances are inherent features of the IGBT, and they may vary from one component to another. In accordance with principles of the present invention, an external controllable capacitor circuit 20 is coupled at the gate of the IGBT to provide an adjustable external gate capacitance C_{G} in parallel with a parasitic gate or input capacitance of the IGBT. The capacitor circuit 20 may be controlled by one or more electrical signals Con_CG to vary the external gate capacitance C_{G}.

The switching speed of the semiconductor switching device can be controlled by the dimensioning of the gate circuit of the semiconductor switching device the gate of the semiconductor power switching device. Gate driver circuits are typically arranged to charge and discharge the gate capacitance C_{ge} (or generally the input capacitance Cᵢₑₛ) so as to switch on and off the IGBT. The magnitude of the gate current Ig, i.e. the charging and discharging rate of the gate charge, can be controlled by varying magnitudes of the gate driver voltage Vcc (Vee), the gate resistor Rg and the external gate capacitance C_{G} (+ the parasitic gate or input capacitance Cin). In embodiments, a fixed gate driver voltage Vcc, e.g., ±15 V, is used, and therefore the switching behaviour is controlled by varying the gate resistance Rg and the external gate capacitance C_{G}.

By changing the gate resistance Rg, the entire switching transient, both a rate of change di/dt of the collector current I_{c} and a rate of change du/dt of the collector voltage V_{c} can be affected. By changing the external gate capacitance C_{G}, the di/dt of the collector current I_{c} can be influenced.

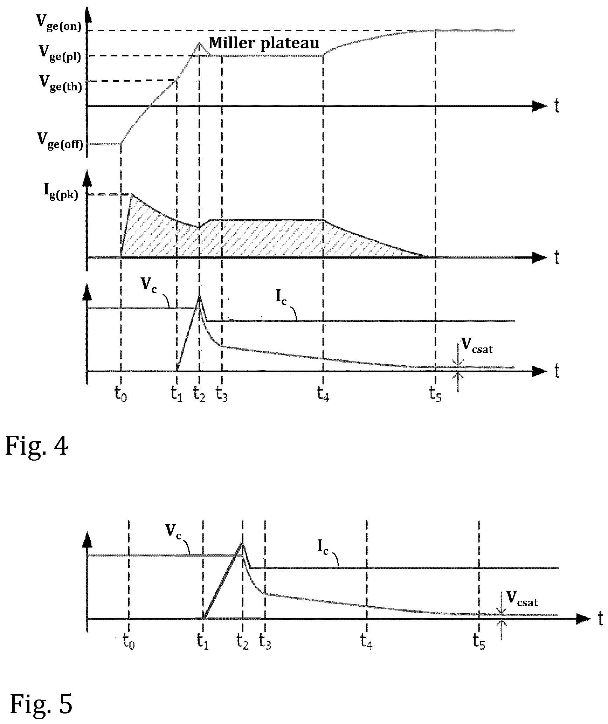

Fig. 4 shows an example of IGBT switching waveforms in the turn-on. A typical application of IGBTs is in switched bridges in power converters, rectifiers, inverters, and like. Fig. 3 illustrates relevant parts of a half-bridge circuit having a lower switch IGBT1 with an antiparallel freewheeling diode D1, and an upper switch IGBT2 with an antiparallel freewheeling diode D2. The lower switch IGBT1 is controlled by a first gate driver 1 and a second gate driver 2. The half-bridge is arranged to drive a load 6 with a load current I_{L}. It is assumed that the switching waveforms illustrated in Fig. 4 are for the lower IGBT1, and that prior to the time instant t0, the lower IGBT1 is in off-state with a gate voltage V_{ge}(off) at the gate G, while the current I_{FWD} I_{FWD} (I_{FWD} = I_{L}) flows via the upper freewheeling diode D2.

At time instant t0, the gate driver 14 of the lower IGBT1 receives a turn-on signal from a control circuitry. The gate driver 14 starts to charge the gate capacitance G_{ge} and the external gate capacitance C_{G} by the gate current I_{g}, and the gate voltage V_{ge} starts to rise. During the interval t0-t1, which is also called a dead time, only the gate capacitor G_{ge} and the external gate capacitance C_{G} are charged. At this stage, the collector has no current and the pole voltage has not changed.

At time instant t1, the gate voltage V_{ge} rises to the turn-on threshold voltage V_{ge}(th), and the commutation of the collector current Ic starts. The gate current I_{g} charges the C_{ge}, C_{G}, and C_{gc} capacitances, the IGBT starts to open, the collector current I_{g} begins to increase, and the gate voltage V_{ge} continues increasing. The commutation of the collector current Ic ends at time instant t₂ when the gate voltage V_{ge} reaches a certain value in which the gate voltage is maintained at a level, which is called the Miller plateau voltage V_{ge}(pl). The Miller plateau voltage, in turn, depends on the characteristics of the IGBT used and the magnitude of the current Ic to be commutated. The higher the current, the higher the Miller voltage. As the collector current Ic increases, the current IFWD through the upper freewheeling diode D2 decreases and finally ends. The peak shown in the collector current Ic is due to the reverse recovery current of the upper freewheeling diode D2 flowing for a short time after the Miller voltage has been reached. The IGBT1 takes over both the reverse current of the freewheeling diode D2 and the load current, i.e., I_{c} = I_{L} + I_{FWD}. At time instant t₂, the reverse recovery current of the upper freewheeling diode D2 has ended, and the collector current I_{c} starts settle to a value corresponding to the load current I_{L}. The reverse recovery current of D2 also causes a peak to the gate voltage V_{ge}. The collector voltage U_{c} decreases rapidly between time instants t₂ - t₃. The gate current I_{g} charging the C_{ge}, C_{G}, and C_{gc} capacitances. At time instant t₃, the gate voltage V_{ge} settles to the Miller voltage. After time instant t₃, since the collector voltage U_{c} decreases gradually towards the saturation voltage V_{csat}. the gate voltage V_{ge} does not rise but will stay approximately constant. At time instant t4, the gate current I_{g} continues to charge the C_{ge} and C_{G} capacitances, the gate voltage V_{ge} begins to rise again. Finally, at time instant t₅, the gate voltage reaches the V_{ge}(on) level, the collector voltage V_{c} reaches the saturation voltage Vcsat. and the entire IGBT1 is fully turned on.

During the current commutation (between t1 and t2), the gate voltage V_{ge} follows an RC curve, whose time constant is determined by the gate resistance Rg and the capacitances Cᵢₑₛ+C_{G}, i.e. τ= Rg(Cᵢₑₛ+C_{G}). By adding an external capacitance C_{G}, the time instant t₁, where the gate voltage V_{ge} reaches the turn-on threshold voltage V_{ge}(th), and the commutation of the collector current Ic starts, can be controlled. Similarly, the time from time instant t1 to t2 where the gate voltage V_{ge} reaches the Miller plateau voltage V_{ge}(pl) and the commutation of the collector current Ic ends, can be controlled. Thereby, the rate of change di/dt of the collector current Ic can be controlled. The turn-on instant t1 of the IGBT1 is delayed, the end of the current commutation t2 is delayed, and the change of rate di/dt of the collector current Ic decreases with the increasing external capacitance C_{G}. This is illustrated in Fig. 5, which depicts exemplary waveforms of the collector current Ic and the collector voltage Vc when the external gate capacitance C_{G} has been increased while the gate resistance Rg is the same compared to the situation in Fig. 4. It shall be appreciated that the Figs. 4 and 5 are only intended to illustrate the effect of the external gate capacitance in a very simplified and coarse manner.

The commutation of the collector voltage V_{ce} starts at time instant t2, when the gate voltage V_{ge} reaches the Miller voltage V_{ge}(pl). Thus, also the starting time t2 of the voltage commutation is delayed with increasing C_{G}, as illustrated in Fig. 3. During the commutation of the collector voltage V_{ce}, the gate voltage V_{ge} is constant and determined by the Miller level. During voltage commutation, the gate current Ig (i.e. the charging or discharging rate of the total gate capacitance) is determined by Ig = (V_{cc}- V_{ge})/RG. Thus, the change of the external gate capacitance C_{G} does not affect on the rate of change du/dt of the voltage commutation, as illustrated in Fig. 5. The du/dt can be influenced by changing the gate resistance Rg.

In embodiments, the controllable capacitor circuit 20 may comprise one or more controllable capacitor legs each of which can be selectively coupled and decoupled in parallel with the internal gate capacitance of the semiconductor power switching device. The capacitor legs can be selectively coupled and decoupled in parallel in different combinations to provide different values of the external gate capacitance C_{G}. With number n of the capacitor legs, the capacitor legs can be selectively coupled and decoupled in 2ⁿ combinations to provide 2ⁿ different values of the external gate capacitance C_{G}, wherein n is an integer equal to or greater than 1.

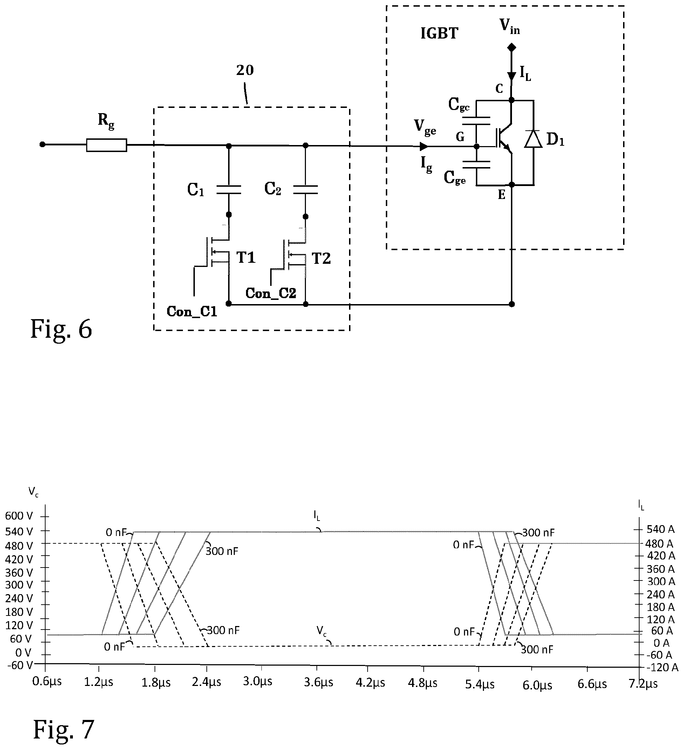

In embodiments, each controllable capacitor leg comprises a capacitor connected in series with a control switch the control switch. Fig. 6 shows a simplified circuit diagram illustrating an exemplary controllable capacitor circuit 20 according to an embodiment having two controllable capacitor legs connected in parallel with the parasitic gate capacitance C_{ge} of IGBT (or generally the parasitic input capacitance Cᵢₑₛ. The first capacitor leg includes an external capacitor C1 and a semiconductor switch T1, while the second capacitor leg includes an external capacitor C2 and a semiconductor switch T2. In embodiments, the semiconductor switches T1 and T2 are low-voltage MOSFETs, e.g. 30 V. In the exemplary controllable capacitor circuit, the semiconductor switches T1 and T2 are selectively turned on and off by control signals Con_C1 and Con_C2 applied to the gates of the semiconductor switches T1 and T2. The control signals Con_C1 and Con_C2 may originate from any suitable control unit or control system, referred to as the controller 10 herein, which is configured to control the operation of one or more the gate drivers, and which may optionally be configured to control overall operation of a switching apparatus where a gate driver is used, such as a DC-DC or DC-AC converter or a motor drive, wherein the gate driver or gate drivers are employed.

With the two capacitor legs, four different values of the external capacitance C_{G} can be obtained:
- T1 on, T2 off, C_{G} = C1
- T1 off, T2 on, C_{G} = C2
- T1 on, T2 on, C_{G} = C1 + C2
- T1 off, T2 off, C_{G} = 0.

In the following, simulation results for a simple test circuit are presented in Fig 7. The test circuit may be as shown in Fig. 6. Discrete IGBT FGW50XS65 was used. Turn-off gate voltage was -5 V, and turn-on gate voltage was 15 V. The switched DC voltage was 500 V, the load current was 500 V with a resistive load of 1 ohm. External gate resistor Rg of 3 ohms was used. External gate capacitors were C1 = 100 nF and C2 = 200 nF. MOSFETS T1 and T2 were controlled by two control signals Con_C1 and Con_C2, respectively. Thereby, four differentval-ues of the external capacitance C_{G} could be obtained:
- T1 on, T2 off, C_{G} = 100 nF
- T1 off, T2 on, C_{G} = 200 nF
- T1 on, T2 on, C_{G} = 300 nF
- T1 off, T2 off, C_{G} = 0.
In Fig. 7, the solid line represents the collector voltage V_{c}. The dashed line represents the load current I_{L}. The left-most graps depict the waveforms with no external gate capacitance and the right-most graphs depict the waveforms with the largest external gate capacitance.

The external gate capacitance C_{G} can be programmed or adjusted by the electrical control signal(s) to adjust the gate capacitance of a semiconductor device to a capacitance value required for an application in question. Parasitic gate capacitances of semiconductor devices vary within manufacturing tolerances and particularly between similar devices of different manufactures. The present invention allows programming the gate capacitance value at set up, calibration or operation of a switching apparatus where a gate driver is used, such as a power converter, rectifier, etc.

In embodiments, the value of the external capacitance C_{G} may be programmed once at set up, calibration, etc., and the value may be unchanged thereafter.

In embodiments, the value of the external capacitance C_{G} may be adjusted dynamically during operation of a switching apparatus according to a predetermined criterium.

In embodiments, the value of the external capacitance C_{G} may be programmed at set up, calibration, etc., of a switching apparatus to a required value, and the value of the external capacitance C_{G} may be fine-adjusted or fine-tuned dynamically during operation of a switching apparatus according to a predetermined criterium.

In embodiments, a controller may have predetermined control settings of the controllable capacitor circuit 20 for certain components or modes of operation. The control settings may be prestored in a memory of the controller. User may select the control setting for the semiconductor component installed and/or operation mode to obtain the suitable value of the external gate capacitance C_{G}.

In embodiments, a switching behaviour of a semiconductor switching component is adjusted by changing the external gate capacitance C_{G} and thereby the total gate capacitance. This allows adjusting the gate capacitance depending on characteristics of a semiconductor switching component driven by the gate driver and installed in a switching apparatus.

In embodiments, a rate of change di/dt of the collector current Ic or the load current I_{L} of a semiconductor switching component is adjusted by changing the external gate capacitance C_{G} and thereby the total gate capacitance. As discussed above, increasing the external gate capacitance decreases the rate of change of current di/dt.

In embodiments, by changing the value of the external gate capacitance C_{G} in relation to a given gate resistance Rg, a lower du/dt of the semiconductor switching component can be achieved with the same switching loss, for example during recovery of a zero diode. In other words, with a single gate driver having a controllable capacitor circuit according to embodiments of the invention, one can select the optimal value of the external gate capacitance C_{G} for each semiconductor switching component having a given value of gate resistance. In embodiments, this functionality can also be used in real time, i.e. to control the external gate capacitance as a function of the sine wave, i.e. to slow down the switching at the zero crossing point of the sine wave, where the du/dt of the semiconductor switching component is inherently largest.

In embodiments, switching delay of a semiconductor switching component is adjusted by changing the external gate capacitance C_{G} and thereby the total gate capacitance. As discussed above, increasing the external gate capacitance delays both the current commutation and the voltage commutation.

In embodiments, switching delays of parallel-connected semiconductor switching components are adjusted by individually adjusting the external gate capacitances C_{G} of the parallel-connected semiconductor components such that the switching occurs as simultaneously as possible. This allows using semiconductor switching components of different manufacturers in parallel-connected switching modules, such as inverters. Typically, the internal gate resistance and internal parasitic gate (input) capacitance of each semiconductor switching component are different, and therefore the switching occurs at different times in different components. The external gate capacitances C_{G} of different parallel-connected components can be individual adjusted to suitable capacitance values which compensate the differences in internal characteristics and cause switching to occur as simultaneous as possible. As the internal parameters of the semiconductor switching components do not change during the operation, the adjustable capacitor circuits 20 can be controlled to suitable capacitance value before the actual use of the switching apparatus. The suitable values of the external gate capacitances C_{G} may be determined by a test procedure. For example, a test pulse or test pulses may be applied to the gates G of the parallel-connected components by the respective gate drivers with different combinations of the external gate capacitance values C_{G} and the differences in switching times are determined. The combination of the external gate capacitance values C_{G} may be selected that causes the most simultaneous switching.

In embodiments, a short-circuit current of a semiconductor switching component is restricted by changing the external gate capacitance C_{G} and thereby the total gate capacitance. Increasing the external gate capacitance C_{G} decreases the gate voltage V_{ge} during the short-circuit. Reducing the gate voltage V_{ge} reduces the saturation current of the semiconductor switching component, which restricts the maximum value of the current during the short-circuit. Restriction of the short-circuit current to a smaller value increases the safety marginal between a peak short-circuit overvoltage and a maximum rated reverse voltage the semiconductor switching component can withstand in the reverse-biased direction before breakdown. In embodiments, upon detecting a short-circuit event, the adjustable capacitor circuit 20 is controlled to increase the external gate capacitance C_{G}, preferably to a maximum capacitance value. During a normal operation, a lower or no external gate capacitance C_{G} is used. In an embodiment, a special-purpose controllable capacitor leg with a large external capacitance, e.g., 1 µF or larger, may be provided and coupled during a short-circuit event.

Switching apparatuses, such as inverters, produce strong magnetic fields that can interfere with the device itself or other devices in its vicinity. Magnetic fields are generated by high current change rates di/dt. As described above, high di/dt values are generated during the switching event of a semiconductor component. Magnetic fields can also be coupled to other circuits inside the apparatus, for example, the connectors of the apparatus can form a loop with the conductive outer casing to which a magnetic field can be coupled. This in turn generates a co-modulated interference current that can propagate outside the apparatus. Protection against magnetic fields is notoriously difficult. Passive filtering required for covariant interference currents. Filters for co-modulated interference currents typically consist of a co-modulated inductor and Y capacitors. If this filtering can be reduced, significant cost and space savings can be achieved.

In embodiments, a magnetic field and/or a common-mode interference current caused by the switching operation of the semiconductor switching component is decreased by adjusting the external gate capacitance C_{G}. Increasing the external gate capacitance C_{G} and thereby the total gate capacitance decreases the of change di/dt of the collector current Ic or the load current I_{L}. On the other hand, the lower is the di/dt, the smaller is the magnetic field and/or a common-mode interference current caused by the switching. So, reducing the di/dt in accordance with embodiments is of great value, as the reduction of a magnetic field and/or a common-mode interference current also reduces the requirements for an external interference filtering. Required passive filtering may be reduced or even omitted, and significant cost and space savings can be achieved. In embodiments, there may be different predetermined control settings of the controllable capacitor circuit 20 for different filter setups. The control settings may be prestored in a memory of the controller. For example, a larger external gate capacitance causing a lower di/dt may be selectable for a setup with no passive filtering, while a smaller external gate capacitance causing a higher di/dt may be selectable for a setup with passive filtering.

The gate driver control, such as the controller 10, controlling the gate driver in accordance embodiments of the invention may be implemented by various means. For example, these techniques may be implemented in hardware (one or more devices), firmware (one or more devices), software (one or more modules), or combinations thereof. For a firmware or software, implementation can be through modules (e.g., procedures, functions, and so on) that perform the functions described herein. The software codes may be stored in any suitable, processor/computer-readable data storage medium(s) or memory unit(s) and executed by one or more processors/computers. The data storage medium or the memory unit may be implemented within the processor/computer or external to the processor/computer, in which case it can be communicatively coupled to the processor/computer via various means as is known in the art.

The description and the related drawings are only intended to illustrate the principles of the present invention by means of examples. Various alternative embodiments, variations and changes are obvious to a person skilled in the art on the basis of this description. The present invention is not intended to be limited to the examples described herein but the invention may vary within the scope and spirit of the appended claims.

## Claims

1. A gate driver comprising:
a gate driver output configured to be coupled to a gate of a semiconductor power switching device, preferably IGBT or MOSFET,
a switching circuit outputting a gate driving voltage to the gate driver output via a series gate resistor,
a controllable capacitor circuit configured to provide an adjustable external gate capacitance at the gate driver output in parallel with an internal gate capacitance of the semiconductor power switching device, the controllable capacitor circuit being selectively controllable to provide at least two different values of the external gate capacitance.

2. The gate driver as claimed in claim 1, wherein the controllable capacitor circuit comprises one or more controllable capacitor legs each of which can be selectively coupled and decoupled in parallel with the internal gate capacitance of the semiconductor power switching device.

3. The gate driver as claimed in claim 2, wherein each controllable capacitor leg comprises a capacitor connected in series with a control switch, the control switch being selectively controllable between a first state where the respective capacitor is coupled in parallel with an internal gate capacitance, and a second state where the respective capacitor is decoupled.

4. The gate driver as claimed in claim 2 or 3, wherein the capacitor legs can be selectively coupled and decoupled in 2ⁿ combinations to provide 2ⁿ different values of the external gate capacitance, where n is number of the capacitor legs.

5. The gate driver as claimed in any one of claims 1-4, wherein the gate driver is configured to select a higher or highest external capacitance value in response to detecting a short circuit so as to restrict a short circuit current.

6. The gate driver as claimed in any one of claims 1-5, wherein the gate driver is configured to select an external capacitance value that provides a desired switching delay of the semiconductor power switching device.

7. The gate driver as claimed in claim 6, wherein the gate driver is configured to select an external capacitance value to adjust the switching delay of the semiconductor power switching device relative to one or more parallel-connected semiconductor power switching devices such that the parallel-connected semiconductor power switching devices are switching as simultaneously as possible.

8. The gate driver as claimed in any one of claims 1-7, wherein the gate driver is configured to select a higher external capacitance value to adjust a current rate of change di/dt of a collector current.

9. The gate driver as claimed in any one of claims 1-8, wherein the gate driver is configured to select a higher external capacitance value to decrease a current rate of change di/dt of a collector current and to thereby decrease a magnetic field and/or a common-mode interference current caused by a switching operation.

10. The gate driver as claimed in any one of claims 1-9, wherein the gate driver is configured to select an external capacitance value that, together with a value of the series gate resistor, results in a lower voltage rate of change du/dtwith a same switching loss.

11. The gate driver as claimed in any one of claims 1-10, wherein the gate driver is configured to dynamically adjust the external capacitance value dynamically at zero-crossing points of a sinusoidal voltage that is switched.

12. The gate driver as claimed in any one of claims 1-11, wherein the external gate capacitance value is set or programmed at set up or calibration or dynamically during operation of a switching apparatus where a gate driver is used.

13. The gate driver as claimed in any one of claims 1-12, wherein the external gate capacitance value is set or programmed using predetermined control settings of the controllable capacitor circuit for certain semiconductor power switching devices or modes of operation.

14. A switching apparatus, comprising
a half or full bridge circuit comprising two or more semiconductor power switching devices,
the gate driver as claimed in any one of claims 1-13 for each of the two or more semiconductor power switching devices,
a controller controlling the controllable capacitor circuits of the gate drivers to adjust the external gate capacitance values.

15. The switching apparatus as claimed in claim 14, wherein the switching apparatus comprises a power converter, an inverter, or a rectifier.
